# EUROPÄISCHE PATENTSCHRIFT

(11) **EP 3 040 816 B1**
(45) Veröffentlichungstag und Bekanntmachung des Hinweises auf die Patenterteilung: **13.03.2019**
(21) Anmeldenummer: 16150190.3
(22) Anmeldetag: 05.01.2016
(51) Int. Cl.: G06F 3/01, G06F 3/0488

(54) **VERFAHREN UND VORRICHTUNG ZUR EINGABE VON DATEN MIT ZWEI EINGABEARTEN UND HAPTISCHER RÜCKKOPPLUNG, INSBESONDERE IN EINEM KRAFTFAHRZEUG**
METHOD AND DEVICE FOR ENTERING DATA WITH TWO TYPES OF INPUT AND HAPTIC FEEDBACK, ESPECIALLY IN A MOTOR VEHICLE
PROCEDE ET DISPOSITIF D'ENTREE DE DONNEES A L'AIDE DE DEUX TYPES D'ENTREE ET RETROACTION HAPTIQUE, EN PARTICULIER DANS UN VEHICULE AUTOMOBILE

(30) Priorität: 05.01.2015 DE 102015200036
(43) Veröffentlichungstag der Anmeldung: 06.07.2016
(73) Patentinhaber: Volkswagen AG, 38440 Wolfsburg (DE)
(72) Erfinder: Czelnik, Mark Peter, 38440 Wolfsburg (DE); Klaas, Michael, 38179 Schwülper (DE); Rieger, Carsten, 38268 Lengede (DE)
(74) Vertreter: Patentanwälte Bressel und Partner mbB

(56) Entgegenhaltungen:
- US-A1- 2008 024 459
- US-A1- 2014 267 114

## Beschreibung

Die Erfindung betrifft ein Verfahren und eine Vorrichtung zur Eingabe von Daten mit haptischer Rückkopplung, insbesondere in einem Kraftfahrzeug.

Moderne Kraftfahrzeuge sind mit einer Vielzahl von Zusatzfunktionen, welche über den reinen Beförderungszweck eines Kraftfahrzeugs hinausgehen, ausgestattet. Dies können beispielsweise Multimediasysteme zum Empfang von Radio oder der Wiedergabe von medialen Inhalten wie Musik, Filmen oder Bildern, sein, Kommunikationssysteme, welche eine weltweite sprach- oder textbasierte Kommunikation ermöglichen, oder auch Navigationssysteme, welche automatisch die Route berechnen, auf der die Fahrtstrecke möglichst zeitsparend und stauvermeidend zurückgelegt werden kann. Weiterhin sind Systeme denkbar, welche dem Fahrer oder einem Techniker in Form eines sogenannten Bordcomputers Auskunft über den Zustand des Kraftfahrzeugs geben. Allen diesen Systemen ist gemein, dass sie eine Interaktion mit dem Fahrzeugführer oder den Beifahrern über verschiedene Eingabe- und Ausgabekanäle ermöglichen und voraussetzen.

Aus dem Stand der Technik sind mehrere Varianten bekannt, wie ein solches System bedient werden kann. Neben den in Kraftfahrzeugen immer mehr verschwindenden physisch ausgebildeten Tasten, Schaltern und Reglern, finden sich vor allem virtuell nachgebildete Bedienelemente, die beispielsweise über ein berührungsempfindliche Anzeige (Touchscreen) betätigt bzw. eingestellt werden können. Um dem Benutzer nach der Bedienung eine Rückmeldung über das Betätigen eines Schalters oder eines Reglers zu geben, sind akustische oder haptische Rückkopplungen üblich. Beispielsweise kann nach einem Tastendruck ein akustisches Signal dem Benutzer den Tastendruck anzeigen und bestätigen. Eine haptische Rückkopplung kann beispielsweise in Form einer Vibration der berührungsempfindlichen Anzeige erfolgen. Diese Vibration wird üblicherweise mit Hilfe von an dem Gehäuse angebrachten Aktoren hervorgerufen.

Aus DE 10 2008 035 907 A1 ist ein berührungsempfindliches Eingabegerät mit berührungskraftabhängiger Zusatzfunktion bekannt. Die Vorrichtung betrifft ein Eingabegerät mit einem Bedienfeld zur Berührung durch ein über das Bedienfeld bewegbares Betätigungselement oder einen Finger eines Bedieners, mit Mitteln zur Erfassung der Position und/oder Bewegung des Betätigungselements oder des Fingers auf dem Bedienfeld und einer Auswerteinheit zur Erzeugung eines der erfassten Größe entsprechenden Steuersignals. Das Eingabegerät zeichnet sich dadurch aus, dass das Bedienfeld in Berührrichtung aus einer Ruhelage aufgrund einer durch das Betätigungselement oder den Finger erzeugten Berührkraft elastisch nachgebend ausgestaltet oder elastisch nachgebend gelagert ist und dabei auf wenigstens einen separaten Drucksensor zur Erzeugung eines der Berührkraft proportionalen Signals einwirkt und dass dessen Signal der Auswerteeinheit zur Erzeugung eines weiteren Steuersignals zugeführt wird. Bei Überschreiten einer Kraftschwelle kann dabei eine Funktion ausgelöst werden und eine haptische Rückkopplung in Form einer Vibration gegeben werden. Die Erfindung betrifft ferner ein zugehöriges Verfahren.

Aus der US 2014/0267114 A1 ist ein Verfahren zum Bereitstellen einer Mensch-Maschine-Schnittstelle bekannt, bei der Gesten auf einer druckempfindlichen Eingabeeinrichtung ausgewertet werden.

Aus der US 2008/0024459 A1 ist eine Vorrichtung mit einer Anzeige und einem Touchscreen bekannt, wobei die Anzeige eine graphische Benutzerschnittstelle darstellt und das Touchscreen eine Berührposition erfasst. Die Vorrichtung ist in der Lage, eine haptische Rückkopplung bereitzustellen. Ein Drucksensor erfasst ferner einen Druck auf den Touchscreen.

Ein Nachteil der vorgenannten Vorrichtungen und Verfahren ist, dass sie zwar eine Positionierung eines Mauszeigers oder einer Auswahlposition über eine berührungsempfindliche Anzeige und ein Auslösen einer Funktion durch Überschreiten einer Kraftschwelle bereit stellen, die Interaktivität der Bedienung aber stark begrenzt ist.

Es ist somit wünschenswert, ein Eingabeverfahren zur Verfügung zu haben, bei dem die Interaktivität der Bedienung erhöht ist und der Bediener intuitiv Funktionen suchen, auswählen und auslösen kann. Dabei sollten für unterschiedliche Arten der Bedienung stets auch eine unterscheidbare haptische Rückkopplung gegeben werden, so dass der Bediener sich schneller zurecht findet, sicherer Funktionen anwählen kann und es zu keiner oder weniger Fehlbedienungen kommt.

Der Erfindung liegt somit das Problem zugrunde, ein Verfahren und eine Vorrichtung zu schaffen, bei dem die Eingabe sowohl flexibel als auch interaktiv ausgestaltet ist.

Die technische Aufgabe wird erfindungsgemäß durch eine Vorrichtung mit den Merkmalen des Patentanspruchs 1 und ein Verfahren mit den Merkmalen des Patentanspruchs 12 gelöst. Vorteilhafte Ausgestaltungen der Erfindung ergeben sich aus den Unteransprüchen.

Der Erfindung liegt der Gedanke zugrunde, mit einer einen Touchscreen aufweisenden Vorrichtung eine interaktive Bedienweise, wie sie von modernen Touchscreens bekannt ist, mit dem Interaktionsprinzip einer klassischen, physisch ausgebildeten, Taste zu kombinieren. Somit werden zwei unterschiedliche Eingabearten geschaffen: eine Eingabeart bilden die Berührgesten, die andere Eingabeart bilden die Druckgesten. Die Schaffung zweier Eingabearten ermöglicht eine flexiblere, differenziertere und damit interaktivere Bedienung der elektronischen Systeme, insbesondere in Kraftfahrzeugen. Durch die Möglichkeit der Steuerung durch Berührgesten und Auslösen der damit verknüpften Berührfunktionen ist eine schnellere und sichere Steuerung, beispielsweise der graphischen Darstellung, gewährleistet. Die Druckgesten dienen hingegen zum Betätigen von Schaltern und Tasten, die als virtuelle Bedienelemente ausgebildet sind. Dabei sind die Druckgesten dadurch gekennzeichnet, dass zum Auslösen von Bedienelementfunktionen eine Kraftschwelle überschritten werden muss. Das Überschreiten einer Kraftschwelle verhindert eine Fehlbedienung, wie sie beispielsweise durch einen frei schwingenden Arm, der durch Fahrbahnunebenheiten unwillentlich bewegt wird, auftritt. Durch eine haptische Rückkopplung während der Druckgeste wird darüber hinaus der sensorische Eindruck einer physischen Taste nachgebildet.

### Definitionen

Eine Berührposition ist ein Ort der Berührung eines Betätigungselements, beispielsweise eines Fingers, mit einer berührungsempfindlichen Oberfläche, beispielsweise der einer frei programmierbaren berührungsempfindlichen Anzeigeeinrichtung, welche die Bestimmung des Orts der Berührung erlaubt. Im Folgenden wird stets von einem Finger als Betätigungselement ausgegangen, ohne den Begriff Betätigungselement jedoch darauf zu beschränken.

Eine Berührspur ist eine zeitliche und örtliche Zusammenfassung mehrerer Berührpositionen. Eine Berührspur besitzt bestimmte Eigenschaften, welche sich aus der Trajektorie der zusammengefassten Berührpositionen ergeben, wie beispielsweise einer Richtung, einer Geschwindigkeit oder einer Beschleunigung. Sie hat einen Startpunkt und einen Endpunkt. Die Berührpositionen müssen nicht notwendigerweise unmittelbar miteinander benachbart sein. Beispielsweise kann ein Doppelklick auch eine Berührspur darstellen. Die Richtung, die Geschwindigkeit und die Beschleunigung ergeben sich jeweils aus der Richtung, der Geschwindigkeit oder Beschleunigung der Betätigungsbewegung des die Berührungen bewirkenden Betätigungselements.

Eine Berührgeste ist eine klassifizierte Berührspur. Dabei werden beispielsweise Eigenschaften, wie Richtung, Geschwindigkeit oder Beschleunigung der Trajektorie mindestens einer Berührspur ausgewertet.

Ein Druckkraftsensor ist eine Einrichtung, welche die Bestimmung eines Anpressdrucks auf einer Oberfläche eines Körpers, beispielsweise einer frei programmierbaren berührungsempfindlichen Anzeigeeinrichtung, durchführt und einen mit dem Anpressdruck korrelierten, vorzugsweise proportionalen, Wert ausgibt, beispielsweise als elektrisches Signal. Ein solcher Druckkraftsensor kann beispielsweise als Dehnungsmessstreifen, als Piezoelement oder als induktiv oder kapazitiv arbeitender Sensor ausgeführt sein.

Eine Druckgeste ist dadurch gekennzeichnet, dass an einer Berührposition ein Überschreiten einer ersten Kraftschwelle, sowie das anschließende Unterschreiten einer zweiten Kraftschwelle, auftritt, wobei die zweite Kraftschwelle geringer als die erste Kraftschwelle ist.

Eine Berührfunktion ist eine Funktion, die von einer Berührgeste ausgelöst wird. Eine solche Berührfunktion kann beispielsweise ein Rollen einer Liste, ein Blättern in einem mehrseitigen Text oder Menü oder ein Vergrößern und Verkleinern einer Ansicht sein.

Eine Bedienelementfunktion ist eine Funktion, welche durch eine Druckgeste ausgelöst wird. Eine Bedienelementfunktion kann beispielweise eine mit einer als virtuelles Bedienelement nachgebildeten Taste verbundene Funktion sein, beispielweise zur Anwahl eines Musiktitels oder eines Menüpunktes.

Ein Auslösebereich ist ein zweidimensionaler Bereich, in dem entweder eine Berührfunktion oder eine Bedienelementfunktion ausgelöst werden können.

Ein virtuelles Bedienelement ist die virtuelle Nachbildung eines physischen Bedienelements. Das virtuelle Bedienelement weist eine graphische Darstellung auf. Der für die Auslösung mittels einer Druckgeste vorgesehene Auslösebereich ist vorzugsweise Deckungsgleich mit dem Darstellungsbereich der graphischen Darstellung des virtuellen Bedienelements.

Eine berührungsempfindliche Positionserfassungseinheit ist ein zweidimensionaler flacher Körper, auf dessen einen dem Benutzer zugewandten Oberfläche mindestens eine Berührposition bestimmt werden kann, wenn sich das Betätigungselement in der Nähe oder auf der Oberfläche des Körpers befindet. Eine solche berührungsempfindliche Positionserfassungseinheit kann beispielsweise ein Touchpad oder ein Touchscreen sein. Die berührungsempfindliche Oberfläche wird als Berührfläche bezeichnet.

Eine Tastatur bezeichnet eine Menge von zueinander angeordneten als virtuelle Bedienelemente ausgebildete Tasten. Eine Tastatur kann beispielsweise eine virtuelle Nachbildung der Tasten in QWERTZ-Anordnung wie bei Standard-PC-Tastaturen oder eines Nummernblocks sein.

Sofern hier vom Erfassen oder Ermitteln der Andruckkraft oder des Anpressdrucks gesprochen wird, ist ein getrennt von der berührungsempfindlichen Postitonserfassung ausgebildetes Erfassen oder Ermitteln gemeint. Dieses erfolgt mit mindestens einem zusätzlich zu der programmierbaren berührungsempfindlichen Anzeigeeinrichtung ausgebildeten Druckkraftsensor.

### Bevorzugte Ausführungsformen

Insbesondere wird somit ein Eingabeverfahren, insbesondere in einem Kraftfahrzeug, mit haptischer Rückkopplung geschaffen, die folgenden Schritte umfassend: Erfassen einer Berührposition auf einer frei programmierbaren berührungsempfindlichen Anzeigeeinrichtung, Selektion einer Funktion über die Berührposition, Erfassen einer Anpressdruckkraft auf die frei programmierbare berührungsempfindliche Anzeigeeinrichtung, Auslösen der selektierten Funktion durch Überschreiten einer ersten Kraftschwelle, Ausgabe einer haptischen Rückkopplung, wobei zeitlich und örtlich benachbarte Berührpositionen zu Berührspuren zusammengefasst werden und die Berührspuren nach Berührgesten klassifiziert werden, wobei Funktionen in Berührfunktionen und Bedienelementfunktionen unterteilt werden und einem Bedienelement in einem ersten Auslösebereich auf der frei programmierbaren berührungsempfindlichen Anzeigeeinrichtung eine Bedienelementfunktion zugeordnet ist, welche durch Überschreiten der ersten Kraftschwelle im Auslösebereich ausgelöst wird, sofern die während eines festgelegten Zeitintervalls zuvor erfassten Berührpositionen in dem Auslösebereich des mindestens einen virtuellen Bedienelements liegen, wobei bei diesem Überschreiten der ersten Kraftschwelle eine haptische Rückkopplung ausgegeben wird und nach anschließendem Unterschreiten einer zweiten Kraftschwelle eine weitere von der ersten unterschiedliche haptische Rückkopplung ausgegeben wird, wobei mindestens einem zweiten Auslösebereich auf der frei programmierbaren berührungsempfindlichen Anzeigeeinrichtung mindestens eine Berührfunktion zugeordnet ist, welche durch eine festgelegte Berührgeste ausgelöst wird.

Ferner wird vorteilhafterweise ein Vorrichtung, insbesondere in einem Kraftfahrzeug, zur interaktiven Eingabe von Daten mit haptischer Rückkopplung geschaffen, welche eine frei programmierbare berührungsempfindliche Anzeigeeinrichtung zum Erfassen einer Berührposition und Darstellen von Information, einen mit der frei programmierbaren berührungsempfindlichen Anzeigeeinrichtung direkt oder indirekt verbundenen Druckkraftsensor zum Erfassen einer Anpressdruckkraft, ein mit der frei programmierbare berührungsempfindliche Anzeigeeinrichtung direkt oder indirekt verbundenes Aktorelement zum Ausgeben einer haptischen Rückkopplung, und eine Steuereinrichtung umfasst, wobei die Steuereinrichtung so ausgebildet ist, dass sie zeitlich und räumlich benachbarte Berührpositionen zu Berührspuren zusammenfasst und nach Berührgesten klassifiziert und die Steuereinrichtung mindestens ein virtuelles Bedienelement auf der frei programmierbaren berührungsempfindlichen Anzeigeeinrichtung darstellt, wobei dem mindestens einen virtuellen Bedienelement ein erster Auslösebereich auf der frei programmierbaren berührungsempfindlichen Anzeigeeinrichtung und eine Bedienelementfunktion zugeordnet wird, wobei die Steuereinrichtung die Anpressdruckkraft überwacht und bei Überschreiten einer ersten Kraftschwelle die Bedienelementfunktion auslöst, sofern die während eines festgelegten Zeitintervalls zuvor erfassten Berührpositionen in dem Auslösebereich des mindestens einen virtuellen Bedienelement liegen, dem die die Bedienelementfunktion zugeordnet ist, wobei bei diesem Überschreiten der ersten Kraftschwelle von der Steuereinrichtung ein Signal an das Aktorelement ausgegeben wird und nach anschließendem Unterschreiten einer zweiten Kraftschwelle ein weiteres von dem ersten Signal unterschiedliches Signal am Aktorelement ausgegeben wird, wobei die Steuereinrichtung mindestens einem zweiten Auslösebereich auf der frei programmierbaren berührungsempfindlichen Anzeigeeinrichtung mindestens eine Berührfunktion zuordnet und bei Auftreten einer festgelegten Berührgeste die mindestens eine Berührfunktion auslöst.

Der Vorteil der Erfindung liegt darin, dass der Bediener sowohl Berührgesten zur einfachen Bedienung, beispielsweise der graphischen Oberfläche, als auch einen von klassischen Tasten bekannten Tastendruck in Form einer Druckgeste zum Auslösen von Bedienelementfunktionen verwenden kann. Über die Berührgesten kann beispielsweise die Menüsteuerung vorgenommen werden, wie das Rollen in Listen oder das Blättern in Menüs. Ebenso denkbar sind das Verschieben von Bild- oder Kartenansichten oder das Vergrößern und Verkleinern dieser Ansichten. Es können aber auch andere Berührfunktionen definiert sein. Die haptische Rückkopplung in Form von zwei nacheinander erfolgenden an die Kraftschwellen gekoppelten voneinander unterschiedlichen Signalen am Aktorelement wird benutzt, um den sensorischen Eindruck einer physisch ausgebildeten Taste, beispielsweise der Taste einer PC-Tastatur oder der Folientastatur eines Mobiltelefons nachzubilden. Es hat sich gezeigt, dass vor allem die zweite haptische Rückkopplung für die realitätsnahe Nachbildung des sensorischen Eindrucks einer Taste notwendig ist. Dem Bediener wird somit eine breite und differenzierte sensorische Rückkopplung über seine Bedienvorgänge gegeben. Die Bedienung wird dadurch interaktiver, einfacher und führt durch die zwei unterschiedlichen Eingabearten und die differenziertere haptische Rückkopplung auch zu weniger Fehlbedienungen, da das Auslösen einer Bedienelementfunktion nur nach Überschreiten der ersten Kraftschwelle möglich ist. Dies ist vor allem bei der Fahrt ein großer Sicherheitsgewinn, da der Fahrer den Blick weniger oft von der Fahrbahn abwenden muss, um seine Eingaben zu kontrollieren. Er hat die Fahrbahn somit stets im Blickfeld und kann trotzdem gezielt Eingaben machen. Ferner ist sichergestellt, dass ein unbeabsichtigtes Auslösen einer Bedienelementfunktion nach einem "Abrutschen" von einem virtuellen Bedienelement beim Erhöhen der Andruckkraft beispielsweise aufgrund einer durch Fahrbahnunebenheiten verursachten Fahrzeugerschütterung nicht erfolgt, da beim Überschreiten der ersten Kraftschwelle die zuvor erfassten Berührposition innerhalb des Auslösebereichs des virtuellen Bedienelements liegen müssen, damit eine Bedienelementfunktion ausgelöst wird. Dies hat den Vorteil, dass Fehlbedienungen reduziert werden.

Insbesondere werden somit eine verbesserte Vorrichtung für ein Kraftfahrzeug und ein verbessertes Verfahren für ein Kraftfahrzeug zur Eingabe von Daten geschaffen.

Bei einer Ausführungsform ist vorgesehen, dass die Berührfunktion nur ausgelöst wird, wenn die Anpressdruckkraft unterhalb der ersten Kraftschwelle liegt. So wird sichergestellt, dass ein Auslöseversuch einer Bedienelementfunktion nicht als Berührfunktion aufgefasst werden kann, beispielsweise wenn der Finger bei der Betätigung eines virtuellen Bedienelements aufgrund einer Fahrzeugerschütterung von diesem "abrutscht".

Auch wenn der Finger über den Auslösebereich eines virtuellen Bedienelements gestrichen wird und die erste Kraftschwelle auf Grund einer Fahrbahnunebenheit und der daraus folgenden Bewegungen des Fingers überschritten wird, erfolgt keine Auslösung der Bedienelementfunktion. Die Fehlbedienung wird erkannt und die zu dem virtuellen Bedienelement gehörende Bedienelementfunktion wird nicht ausgelöst.

Allgemein lässt sich die Erfindung auf sämtliche interaktive Bedienungen und Menüformen anwenden, beispielsweise der Karteninteraktion in einem Navigationssystem, bei der Texteingabe auf einer virtuellen Tastatur (Speller), der Listeninteraktion, beispielsweise bei der Zielwahl im Navigationssystem oder der Titelauswahl beim CD- oder MP3-Spieler, der vertikalen Listeninteraktion oder in der Interaktion mit einem Menüband, der Interaktion mit einer graphischen Liste, beispielsweise einer Liste aus den Covern von Musikalben (CoverFlow), sowie beim Einstellen von Schiebereglern, Drehreglern, Tastern, Schaltern oder sonstigen virtuellen Bedienelementen.

Eine besonders vorteilhafte Ausführungsform sieht vor, dass zeitgleich oder nach- bzw. vorverzögert mit den haptischen Rückkopplungen ein akustisches Signal ausgegeben wird. Dabei kann das akustische Signal beispielsweise ein Klangsample einer physisch ausgebildeten Taste sein, beispielsweise der typische Klicklaut, der beim Druck auf die Taste entsteht. Es können aber auch andere Klänge das akustische Signal bilden. Das akustische Signal für jede einzelne der haptischen Rückkopplungen kann dabei gleich oder verschieden sein. Denkbar ist auch, dass die Berührspuren akustische Signale auslösen, beispielsweise das Abspielen eines Klangsamples, das den Klang des Umblätterns einer Buchseite darstellt, und das beim Blättern in einem Menü abgespielt wird. Der Vorteil einer zusätzlichen akustischen Rückkopplung ist, dass die haptische Rückkopplung vom Bediener auf Grund von wahrnehmungspsychologischen Effekten stärker wahrgenommen wird. Dies kann ausgenutzt werden, indem beispielsweise die Stärke der haptischen Rückkopplung reduziert wird, was zu einem geringeren Verschleiß des Aktorelements beiträgt und somit vorteilhaft für eine lange Lebensdauer ist.

Besonders bevorzugt wird das akustische Signal an einem Lautsprecher ausgegeben, der sich in der Nähe oder an der Position der Vorrichtung, besonders vorzugsweise der berührungsempfindlichen Positionserfassungseinrichtung, befindet. Der Bediener verknüpft dann automatisch das akustische Signal mit der haptischen Rückkopplung und somit mit dem Bedienvorgang an der Vorrichtung. Ebenso denkbar ist die Ausgabe des akustischen Signals über einen oder mehrere Lautsprecher eines im Kraftfahrzeug vorhandenen Multimediasystems, beispielsweise eines Mehrkanalmultimediasystems.

Eine bevorzugte Ausführungsform der Erfindung sieht vor, dass sich der erste Auslösebereich und der zweite Auslösebereich überlappen. Dadurch ist es möglich, einen flächigen Bereich sowohl mit Berührfunktionen als auch mit Bedienelementfunktionen zu versehen. Beispielsweise kann so eine Taste in einer Karte positioniert werden. Beispielsweise kann die Karte dann über die Berührgesten verschoben werden, wobei sich die Taste mitverschiebt. Will der Bediener dann die mit der Taste verknüpfte Bedienelementfunktion auslösen, drückt er auf die Taste und löst sie aus, in dem er die erste Kraftschwelle überschreitet. Damit kann die Bedienoberfläche und die Interaktion flexibler ausgestaltet werden.

Idealerweise wird eine Ausführungsform realisiert, bei der die Bedienelementfunktion bei Überschreiten der ersten Kraftschwelle nicht ausgelöst wird, wenn sich das Überschreiten der ersten Kraftschwelle an einem Punkt einer Berührspur ereignet, die als Berührgeste klassifiziert ist. Dadurch wird gewährleistet, dass es zu keiner Fehlbedienung kommt, wenn beispielsweise eine Berührspur einen Anfangspunkt außerhalb eines virtuellen Bedienelements besitzt, darauf folgende Punkte sich aber im Bereich des virtuellen Bedienelements befinden.

Eine Ausführungsform sieht vor, dass das Auslösen der Berührfunktion nur erfolgt, wenn die Anpressdruckkraft während des Erfassens der Berührpositionen, die die Berührgeste darstellenden Berührspur ergeben, unterhalb der ersten Kraftschwelle liegt.

Bei einer weiteren Ausführungsform ist vorgesehen, dass die Bedienelementfunktion eine Totzeit besitzt. Beispielweise kann eine Bedienelementfunktion nach einem Auslösen durch Überschreiten der ersten Kraftschwelle erst nach einer bestimmten Zeit erneut ausgelöst werden. Dies soll verhindern, dass es zu unerwünschten Mehrfachauslösungen der Bedienelementfunktion und damit zu einer unerwünschten Fehlbedienung kommt.

Eine weitere bevorzugte Ausführungsform sieht vor, dass auch bei den Berührfunktionen eine haptische Rückkopplung über das Aktorelement ausgegeben wird. Dies ermöglicht neben der visuellen Rückkopplung eine weitere sensorische Rückkopplung. Dadurch wird die Bedienung erleichtert und Fehlbedienungen verringert.

Eine weitere Ausführungsform sieht vor, dass neben der ersten und der zweiten Kraftschwelle weitere Kraftschwellen definiert werden, welche eine haptische Rückkopplung auslösen. Die weiteren Kraftschwellen und die korrespondierenden haptischen Rückkopplungen können beispielsweise dazu verwendet werden, das sensorische Empfinden einer physischen Taste noch genauer nachzubilden. Beispielsweise könnte der Kraftverlauf und das Verhalten einer physischen während des Tastendruckes aufgezeichnet werden und anschließend mit Hilfe der ersten, der zweiten und der weiteren Kraftschwellen und korrespondierenden haptischen Rückkopplungen nachgebildet werden. So ist es möglich, verschiedene physische Tasten exakt nachzubilden. Vorzugsweise wird zeitgleich das akustische Verhalten einer physischen Taste aufgezeichnet und später durch die Vorrichtung zeitgleich oder nach- bzw. vorverzögert mit den haptischen Rückkopplungen abgespielt. So entsteht für den Bediener der Eindruck, eine physisch ausgebildete Taste zu betätigen.

In einer besonders vorteilhaften Ausführungsform umfasst die Vorrichtung eine Schnittstelle zum Datenaustausch. Beispielsweise stellt die Steuereinrichtung an der Schnittstelle die Berührposition, die ausgelöste Bedienelementfunktion oder Berührfunktionen und/oder weitere Daten bereit. Die Schnittstelle kann eine Standardschnittstelle sein, beispielsweise der in Kraftfahrzeugen übliche CAN-Bus. Die Schnittstelle kann aber auch anders ausgeführt sein.

In einer Ausführungsform wird die Steuereinrichtung über die Schnittstelle gesteuert. Dies ermöglicht beispielsweise, dass das Verfahren und die dazugehörige Vorrichtung über einen externen Computer oder Controller, beispielsweise einen Hauptrechner des Kraftfahrzeugs gesteuert wird. So können beispielsweise die Menüfunktionen und die Positionen der Auslösebereiche der virtuellen Bedienelemente von dem Hauptrechner über die Schnittstelle an die Steuereinrichtung geschickt werden, welche diese dann auf der berührungsempfindlichen Anzeige darstellt. Die Interaktion mit dem Bediener erfolgt anschließend: er betätigt beispielsweise ein virtuelles Bedienelement und löst durch Überschreiten der ersten Kraftschwelle die Bedienelementfunktion aus, wobei das Auslösen der Bedienelementfunktion über die Schnittstelle an den Hauptrechner geschickt wird, wo die Information weiterverarbeitet wird. Beispielsweise wird dadurch eine neue Menüseite generiert, welche dann nach erneuter Kommunikation mit der Steuereinrichtung über die Schnittstelle auf der frei programmierbaren berührungsempfindlichen Anzeigeeinrichtung dargestellt wird.

In einer besonders vorteilhaften Ausführungsform der Erfindung ist vorgesehen, dass die auf der frei programmierbaren berührungsempfindlichen Anzeigeeinrichtung dargestellte Information ändert, wenn eine Gestenfunktion oder einer Bedienelementfunktion ausgelöst wurde. Beispielsweise kann sich die graphische Darstellung eines virtuellen Bedienelements während der Druckgeste verändern. So kann beispielsweise eine physische Taste nachgebildet werden durch eine 3D-Animation oder einen Schattenwurf. Bei einer Gestenfunktion könnte beispielsweise graphisch die Berührspur nachgezogen werden. Es sind aber auch andere Möglichkeiten denkbar, wie sich die dargestellte Information ändern kann. Dies ermöglicht eine zusätzliche visuelle Rückkopplung bzw. erweiterte Interaktionsmöglichkeiten.

Bei einer bevorzugten Ausführungsform werden die haptischen Rückkopplungen als impulsartige Auslenkungen einer Berührfläche der frei programmierbaren Anzeigefläche ausgeführt, die vorzugsweise eine Auslenkung und Rückkehr der Berührfläche in eine Ruhe- oder Ausgangslage und gegebenenfalls ein oder mehrere stark bedämpfte Nach- oder Überschwinger aufweisen.

In einer Ausführungsform ist insbesondere vorgesehen, dass die Vorrichtung für eine Integration in einen Innenraum eines Kraftfahrzeugs ausgebildet ist, insbesondere in ein Cockpit des Kraftfahrzeugs, oder eine Kopfstütze, einen Dachhimmel oder eine Mittelkonsole im hinteren Bereich des Kraftfahrzeugs.

Sämtliche Ausführungsformen, welche für ein Kraftfahrzeug beschrieben sind, können auch in weiteren Ausführungsformen ohne das Kraftfahrzeug realisiert werden. So können das erfindungsgemäße Eingabeverfahren und die erfindungsgemäße Vorrichtung in sämtlichen Gebieten, in denen eine Maschine-Mensch-Interaktion an einer Mensch-Maschine-Schnittstelle stattfindet, ausgebildet sein, beispielsweise in einem Computer, einem Laptop, einem Tabletcomputer, einem Smartphone, einem interaktiven Tisch, einem Fahrkartenautomat, einer Infosäule, einer interaktiven Steuerungsvorrichtung, in Leitständen und in Computern, welche blinde Personen unterstützen.

Nachfolgend wird die Erfindung anhand bevorzugter Ausführungsbeispiele unter Bezugnahme auf die Figuren näher erläutert. Hierbei zeigen:
- Fig. 1: eine schematische Darstellung einer Ausführungsform der Vorrichtung zur Eingabe von Daten mit haptischer Rückkopplung;
- Fig. 2: eine schematische Frontansicht einer Ausführungsform der Vorrichtung in einem Kraftfahrzeug zur Eingabe von Daten mit haptischer Rückkopplung;
- Fig. 3: eine rückseitige Explosionsansicht einer Ausführungsform der Vorrichtung;
- Fig. 4: eine schematische Darstellung einer Kartenansicht auf der frei programmierbaren berührungsempfindlichen Anzeigeeinrichtung und beider Eingabearten;
- Fig. 5: eine schematische Darstellung einer Tastatur auf der der frei programmierbaren berührungsempfindlichen Anzeigeeinrichtung und beider Eingabearten;
- Fig. 6: eine schematische Darstellung einer vertikalen Liste auf der der frei programmierbaren berührungsempfindlichen Anzeigeeinrichtung und beider Eingabearten;
- Fig. 7: eine schematische Darstellung einer horizontalen Liste auf der frei programmierbaren berührungsempfindlichen Anzeigeeinrichtung und beider Eingabearten;
- Fig. 8: eine schematische Darstellung einer Coverliste auf der der frei programmierbaren berührungsempfindlichen Anzeigeeinrichtung und beider Eingabearten;
- Fig. 9: eine schematische Darstellung von Schiebereglern auf der der frei programmierbaren berührungsempfindlichen Anzeigeeinrichtung und beider Eingabearten;
- Fig. 10: eine schematische Darstellung von Lagereglern auf der der frei programmierbaren berührungsempfindlichen Anzeigeeinrichtung und beider Eingabearten;
- Fig. 11a,b: eine schematische Darstellung des Verlaufs der Anpressdruckkraft und einer ersten und einer zweiten Kraftschwelle;
- Fig. 12: ein schematisches Ablaufdiagramm des Verfahrens;
- Fig. 13: eine Ausführungsform der Vorrichtung 1 zur Eingabe von Daten in einer Mensch-Maschine-Schnittstelle 60.

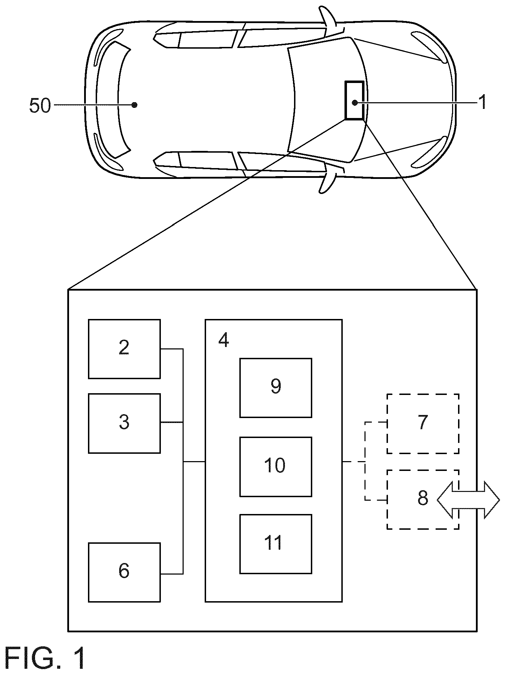

In Fig. 1 ist eine Ausführungsform der Vorrichtung 1 zur Eingabe von Daten gezeigt. In einem Kraftfahrzeug 50 befindet sich die Vorrichtung 1 in der Fahrgastzelle, beispielsweise in der Mittelkonsole. Die Vorrichtung umfasst eine frei programmierbare berührungsempfindliche Anzeigeeinrichtung 2, mit der direkt oder indirekt ein Aktorelement 3 und ein Druckkraftsensor 6 verbunden sind. Die frei programmierbare berührungsempfindliche Anzeigeeinrichtung 2 weist eine Berührfläche 12 auf. Die frei programmierbare berührungsempfindliche Anzeigeeinrichtung 2, das Aktorelement 3 und der Druckkraftsensor 6 sind mit einer Steuereinrichtung 4 verbunden. Die Steuereinrichtung 4 umfasst eine Integriereinrichtung 9, eine Klassifikationseinrichtung 10 und eine Vergleichseinrichtung 11. Optional kann die Vorrichtung 1 einen mit der Steuereinrichtung 4 verbundenen Lautsprecher 7, vorzugsweise an oder in der Nähe der frei programmierbaren berührungsempfindlichen Anzeigeeinrichtung 2, aufweisen. Ebenfalls optional ist eine mit der Steuereinrichtung 4 verbundene Schnittstelle 8 zur Kommunikation mit externen Geräten.

Von der Steuereinrichtung 4 werden virtuelle Bedienelemente und erste und zweite Auslösebereiche definiert. Die virtuellen Bedienelemente werden als graphische Repräsentation auf der frei programmierbaren berührungsempfindlichen Anzeigeeinrichtung 2 dargestellt. Darüber hinaus können durch die Steuereinrichtung 4 weitere graphische Repräsentationen, Symbole, Buchstaben oder Piktogramme auf der frei programmierbaren berührungsempfindlichen Anzeigeeinrichtung 2 dargestellt werden. Von der frei programmierbaren berührungsempfindlichen Anzeigeeinrichtung 2 wird mindestens eine Berührposition erfasst und der Steuereinrichtung 4 zugeführt. Die Integriereinrichtung 9 fasst zeitlich und örtlich benachbarte Berührpositionen zu Berührspuren zusammen und gibt die Berührspuren an die Klassifikationseinrichtung 10 weiter. Die Klassifikationseinrichtung 10 klassifiziert die Berührungsspuren nach Berührgesten.

Zeitgleich mit dem Erfassen der mindestens einen Berührposition wird ein Anpressdruck auf die frei programmierbare berührungsempfindliche Anzeigeeinrichtung 2 von dem Druckkraftsensor 6 erfasst und an die Steuereinrichtung 4 weitergeleitet. Die Vergleichseinrichtung 11 vergleicht nun die klassifizierten Berührspuren und den Anpressdruck beispielsweise mit einer in der Vergleichseinrichtung 11 oder der Steuereinrichtung 4 hinterlegten Liste von Berührfunktionen und Bedienelementfunktionen. Erfüllt eine klassifizierte Berührspur die Kriterien einer der in der Liste gespeicherten Berührfunktionen, so wird die entsprechende Berührfunktion ausgelöst. Optional kann die Steuereinrichtung 4 bei Auslösen der Berührfunktion zeitgleich ein Signal am Aktorelement 3 und/oder ein weiteres Signal am Lautsprecher 7 ausgeben. Ist eine erste Kraftschwelle am Druckkraftsensor 6 überschritten und liegen die in einer vorgegeben Zeitspanne hiervor erfassen Berührpositionen alle in dem Auslösebereich eines virtuellen Bedienelements, so wird die diesem Bedienelement zugeordnete Bedienelementfunktion ausgelöst und die Steuereinrichtung 4 gibt beim Überschreiten der ersten Kraftschwelle ein Signal am Aktorelement 3 aus; wird anschließend eine zweite Kraftschwelle am Druckkraftsensor 6 unterschritten, so gibt die Steuereinrichtung 4 ein weiteres Signal an dem Aktorelement 3 aus. Optional kann beim Überschreiten der ersten Kraftschwelle und/oder beim Unterschreiten der zweiten Kraftschwelle jeweils zeitgleich oder gegenüber dem entsprechenden Signal an das Aktorelement 3 nach- bzw. vorverzögert ein Signal oder mehrere Signale von der Steuereinrichtung 4 auf dem Lautsprecher 7 ausgegeben werden. Eine Überprüfung, ob alle Berührpositionen in der vorgegebenen Zeitspanne vor dem Überschreiten der ersten Kraftschwelle in dem Auslösebereichs eines virtuellen Bedienelements lagen oder liegen, kann beispielsweise von der Vergleichseinrichtung zum Klassifizieren der Berührspuren durchgeführt werden. Dafür wird der dem virtuellen Bedienelement zugeordnete erste Auslösebereich wie ein zweiter Auslösebereich behandelt, wobei eine Berührspur als stationär oder quasistationär klassifiziert wird, wenn alle Berührpositionen in dem vorgegebenen Auslösebereich liegen. Wird eine stationäre oder quasi stationäre Berührspur für einen ersten Auslösebereich klassifiziert, ist die Bedingung erfüllt, sofern die Berührspur zumindest alle Berührpositionen umfasst, die innerhalb der vorgegeben Zeitspanne liegen.

Je nach Art der Berührfunktion oder Bedienelementfunktion, die ausgelöst wurde, kann die Steuereinrichtung 4 die graphische Darstellung auf der frei programmierbaren berührungsempfindlichen Anzeigeeinrichtung 2 verändern oder unverändert lassen. Optional können die Berührposition, der Anpressdruck, die Berührspur und/oder weitere Daten an der Schnittstelle 8 ausgegeben werden. Ebenfalls möglich ist, dass die Steuereinrichtung 4 über die Schnittstelle 8 parametriert wird, beispielsweise von einem Zentralcomputer des Kraftfahrzeugs 50.

Vorzugsweise ist die Vorrichtung so ausgebildet, dass die Aufgaben der Integriereinrichtung 9, der Klassifikationseinrichtung 10, der Vergleichseinrichtung 11, sowie allgemein der Steuereinrichtung 4 softwaremäßig, beispielsweise in einem einzigen Computer oder Mikrocontroller, durchgeführt werden.

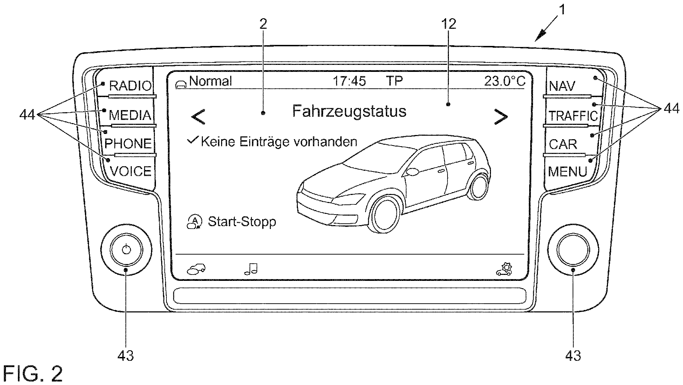

In Fig. 2 ist schematisch eine Ausführungsform der Vorrichtung 1 in Frontansicht abgebildet. Die Vorrichtung 1 ist dabei integriert in eine multimediale Anzeige-Bedienvorrichtung 40, wie sie heutzutage in Kraftfahrzeugen der Mittel- und Oberklasse üblich sind. In der Frontansicht sichtbar ist nur die frei programmierbare berührungsempfindliche Anzeigeeinrichtung 2. Die Steuereinrichtung 4, der Druckkraftsensor 6 und das Aktorelement 3, sowie der optionale Lautsprecher 7 sind in der Frontansicht nicht sichtbar. Neben der frei programmierbaren Anzeigevorrichtung 2 sind physisch ausgebildeten Tasten 44 angeordnet. Sie ermöglichen eine direkte Auswahl von bestimmten Bedienkontexten auf der frei programmierbaren Anzeigeeinrichtung 2. Ferner umfasst die Anzeige-Bedienvorrichtung 40 zwei physisch ausgebildete Endlosdrehregler 43, welche ebenfalls kontextabhängig verwendet werden, beispielsweise zum Einstellen der Lautstärke oder eines Radiosenders.

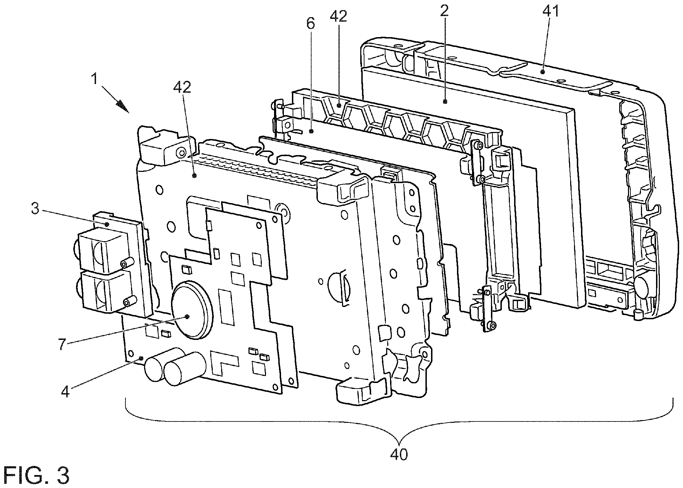

Fig. 3 zeigt eine perspektivische rückseitige Explosionsansicht einer Ausführungsform der Vorrichtung 1. Hinter einer Frontblende 41 einer multimedialen Anzeige-Bedienvorrichtung 40 befindet sich eine frei programmierbare berührungsempfindliche Anzeigeeinrichtung 2. Hinter der frei programmierbaren berührungsempfindlichen Anzeigeeinrichtung 2 befindet sich eine Halterung, an der ein Druckkraftsensor 6 oder Druckkraftsensoren ausgebildet sind. An der Rückseite der Anzeige-Bedienvorrichtung 40 befindet sich eine Steuereinrichtung 4 und ein mit dem Gehäuse direkt oder indirekt verbundenes Aktorelement 3. Das von der Steuereinrichtung 4 zur haptischen Rückkopplung am Aktorelement 3 ausgegebene Signal pflanzt sich über die Halterung der Anzeige-Bedienvorrichtung 40 bis zur frei programmierbaren berührungsempfindlichen Anzeigeeinrichtung 2 fort und überträgt sich somit auf den Finger des Bedieners. Das Aktorelement 3 kann dabei entweder parallel oder senkrecht zur Ebene der frei programmierbaren berührungsempfindlichen Anzeigeeinrichtung 2 ausgelenkt werden. In einer Ausführungsform findet eine Auslenkung durch das Aktorelement 3 nur parallel zur Fläche der frei programmierbaren berührungsempfindlichen Anzeigeeinrichtung 2 statt. Eine parallele Auslenkung hat den Vorteil, dass die frei programmierbare berührungsempfindliche Anzeigeeinrichtung 2 steifer hinsichtlich einer Auslenkung oder Durchbiegung in Betätigungsrichtung, d.h. senkrecht zur Anzeigefläche, ausgeführt werden kann, was dem Bediener die Anmutung einer höheren qualitativen Wertigkeit der Anzeige-Bedienvorrichtung 40 gibt. Darüber hinaus kann bei paralleler Auslenkung der Abstand zwischen der frei programmierbaren berührungsempfindlichen Anzeigeeinrichtung 2 und der Frontblende 41 bzw. anderen Elementen der Anzeige-Bedienvorrichtung 40 kleiner sein, so dass es auf Grund eines kleineren Spaltmaßes zu einer geringeren Verunreinigung des Innenraums der Anzeige-Bedienvorrichtung 40 durch Staub etc. kommt. Eine senkrechte Auslenkung des Aktorelements 3 hat hingegen den Vorteil, dass der Bediener die haptische Rückkopplung am Finger stärker wahrnimmt und dadurch das Signal am Aktorelement 3 geringer ausgeprägt sein kann.

Optional befindet sich an der Steuereinrichtung 4 ein Lautsprecher 7. Die Positionierung des Lautsprechers 7 in die Nähe der berührungsempfindlichen Positionserfassungseinrichtung 2 und der Anzeigeeinrichtung 5 hat den Vorteil, dass das akustische Signal von dem Bediener mit der Position der Anzeige-Bedienvorrichtung 40 im Kraftfahrzeug assoziiert wird. Diese durch wahrnehmungspsychologische Überlegungen motivierte Anordnung erhöht die Wahrnehmung der Rückkopplung beim Bediener. Auf Grund der verstärkten Wahrnehmung von gemeinsamer akustischer und haptischer Rückkopplung kann die Stärke des Signals am Aktorelement 3 bei gleichem sensorischen Eindruck verringert werden, was den Verschleiß des Aktorelements 3 verringert und somit die Lebensdauer des Aktorelements 3 erhöht. Weitere Gehäuseteile 42 dienen der Befestigung oder Versteifung der multimedialen Anzeige-Bedienvorrichtung 40.

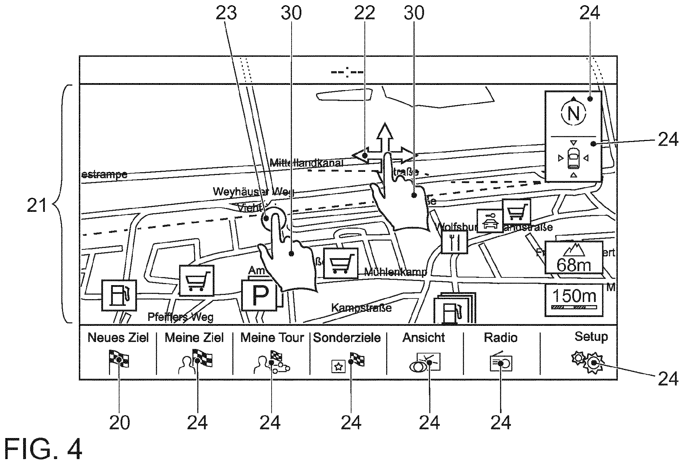

In Fig. 4 ist eine schematische Darstellung einer Straßenkarte 21, beispielsweise zur Zielführung oder -eingabe in einem Navigationssystem, auf einer frei programmierbaren berührungsempfindlichen Anzeigeeinrichtung 2 zur Verdeutlichung der beiden Eingabearten abgebildet. Der Finger eines Bedieners 30 kann direkt dargestellte Positionen auf der frei programmierbaren berührungsempfindlichen Anzeigeeinrichtung berühren, so dass die Berührposition erfasst werden kann. Auf der frei programmierbaren berührungsempfindlichen Anzeigeeinrichtung ist ein virtuelles Bedienelement 20, beispielsweise eine mit einer Bedienelementfunktion verknüpfte Taste zur Anwahl eines neuen Zieles, dargestellt. Ebenfalls dargestellt sind weitere virtuelle Bedienelemente 24, welche mit anderen Bedienelementfunktionen verknüpft sind. Der Bediener kann nun über das Berühren mit dem Finger des Bedieners 30 interaktive Steuerungen vornehmen. Beispielsweise kann durch eine Berührgeste 22, beispielsweise einem Hin- und Herzwischen mit dem Finger des Bedieners 30, die Straßenkarte 21 durch Auslösen einer Berührfunktion verschoben werden. Die Berührfunktion ändert dann den auf der frei programmierbaren berührungsempfindlichen Anzeigeeinrichtung dargestellten Bereich der Straßenkarte 21. Ebenfalls für eine Straßenkarte 21 denkbar sind beispielsweise Berührgesten zum Vergrößern oder Verkleinern, Drehen oder Zentrieren der Straßenkarte 21. Der zweite Auslösebereich für die Berührfunktionen ist bei dieser Ausführungsform mit der gesamten Anzeigefläche identisch. Bei anderen Ausführungsformen kann es mehrere zweite Auslösebereiche geben, die disjunkt voneinander oder überlappend sind. Bei disjunkten zweiten Auslösebereichen kann derselben Berührgeste abhängig von dem jeweiligen Auslösebereich eine unterschiedliche Berührfunktion zugeordnet sein.

Die mit dem virtuellen Bedienelement 20 und den weiteren virtuellen Bedienelementen 24 verknüpften Bedienelementfunktionen können nur über eine Druckgeste 23 ausgelöst werden. Dazu muss der Finger des Bedieners 30 durch Druck auf die frei programmierbare berührungsempfindliche Anzeigeeinrichtung im Auslösebereich des virtuellen Bedienelements eine erste Kraftschwelle überschreiten. Der Auslösebereich ist hier beispielsweise identisch mit dem Darstellungsbereich des virtuellen Bedienelements. Beim Überschreiten der ersten Kraftschwelle wird eine Bedienelementfunktion, hier beispielsweise die interaktive Auswahl eines Zielortes auf der Straßenkarte 21, ausgelöst. Zeitgleich erfolgt eine haptische Rückkopplung über ein Aktorelement, das direkt oder indirekt mit der frei programmierbaren berührungsempfindlichen Anzeigeeinrichtung verbunden ist. Diese haptische Rückkopplung, beispielsweise durch Ausgabe eines Impulses oder anderen Signales über das Aktorelement, überträgt sich auf den Finger des Bedieners 30, so dass der Bediener das Signal sensorisch wahrnimmt.

Im weiteren Verlauf der Druckgeste 23 verringert der Finger des Bedieners 30 den Anpressdruck auf die frei programmierbare berührungsempfindliche Anzeigeeinrichtung und beim Unterschreiten einer zweiten Kraftschwelle erfolgt eine weitere haptische Rückkopplung durch Ausgabe eines weiteren Impulses oder Signals am Aktorelement. Über die erste und die zweite Kraftschwelle, so wie die sich voneinander unterscheidenden haptischen Rückkopplungen ist es möglich, die sensorische Erfahrung beim Drücken einer physischen Taste nachzubilden, so dass dem Bediener eine differenziertere sensorische Erfahrung gegeben werden kann. Optional kann an einem Lautsprecher zeitgleich mit den haptischen Rückkopplungen jeweils ein akustisches Signal ausgegeben werden, beispielsweise ein Klangsample, das den Klang beim Drücken einer physischen Taste nachbildet. Wenn notwendig kann dieses Signal gegenüber der ersten und/oder zweiten Kraftschwelle nach- oder vorverzögert sein, um Laufzeiten des Schalls zu kompensieren bzw. die Wahrnehmung möglichst realistisch zu gestalten. Vorzugsweise sind die beiden Klangsample für die beiden haptischen Rückkopplungen unterschiedlich.

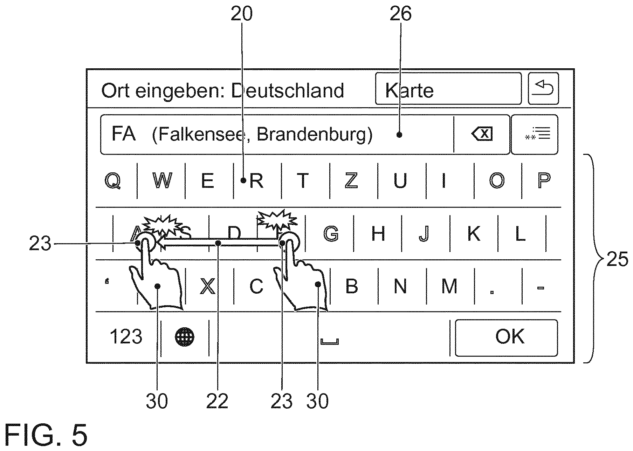

In Fig. 5 ist schematisch ein weiteres Beispiel für die Interaktion über die beiden Eingabearten dargestellt. Auf einer frei programmierbaren berührungsempfindlichen Anzeigeeinrichtung ist eine Tastatur 25 dargestellt. Die Tastatur 25 besteht aus einzelnen Tasten, welche jeweils einen Buchstaben des lateinischen Alphabets repräsentieren. Jede Taste ist ein virtuelles Bedienelement, beispielhaft ist hier jedoch nur ein virtuelles Bedienelement 20 für die Taste zum Buchstaben "R" markiert. Die anderen Tasten wurden aus Gründen der Übersichtlichkeit nicht extra markiert. Eine typische Eingabe wird nun anhand der Eingabe der zwei Buchstaben "F" und "A" erläutert. Der Bediener setzt den Finger 30 auf den Auslösebereich des virtuellen Bedienelements 20, das zum Buchstaben "F" gehört. Dort erhöht er den Anpressdruck und überschreitet mit dieser Druckgeste 23 eine erste Kraftschwelle. Dieses Überschreiten der ersten Kraftschwelle löst eine Bedienelementfunktion aus, in diesem Fall die Eingabe des Buchstabens "F" in das Eingabefeld 26. Zeitgleich wird ein Impuls oder ein anderes Signal über ein Aktorelement ausgegeben. Danach verringert der Finger 30 des Bedieners den Anpressdruck und unterschreitet eine zweite Kraftschwelle. Das Unterschreiten der zweiten Kraftschwelle führt zu einer weiteren Ausgabe eines weiteren Impulses oder eines weiteren Signals über das Aktorelement. Optional kann zeitgleich oder nach- bzw. vorverzögert ein akustisches Signal über einen Lautsprecher ausgegeben werden. Nach der Eingabe des Buchstabens "F" belässt der Bediener den Finger 30 auf der Oberfläche der berührungsempfindlichen Positionserfassungseinrichtung und überstreicht zwei Tasten nach links und positioniert den Finger 30 auf dem virtuellen Bedienelement bzw. der Taste, die zum Buchstaben "A" gehört. Bei dieser Berührgeste 22 kann eine Berührfunktion ausgelöst werden, beispielsweise in Form einer Ausgabe einer haptischen, visuellen oder optischen Rückkopplung, oder es wird keine Funktion ausgelöst. Auf dem virtuellen Bedienelement angekommen, führt der Finger 30 des Bedieners wieder eine Druckgeste 23 aus und gibt somit den Buchstaben "A" in das Eingabefeld 26 ein. Die haptische bzw. akustische Rückkopplung erfolgt analog zur oben geschilderten Druckgeste 23 auf die Taste des Buchstabens "F".

Abweichend von der beschriebenen Ausführungsform kann das Eingeben oder Erfassen der Buchstaben "F" und "A" auch jeweils erst beim Unterschreiten der zweiten Kraftschwelle erfolgen.

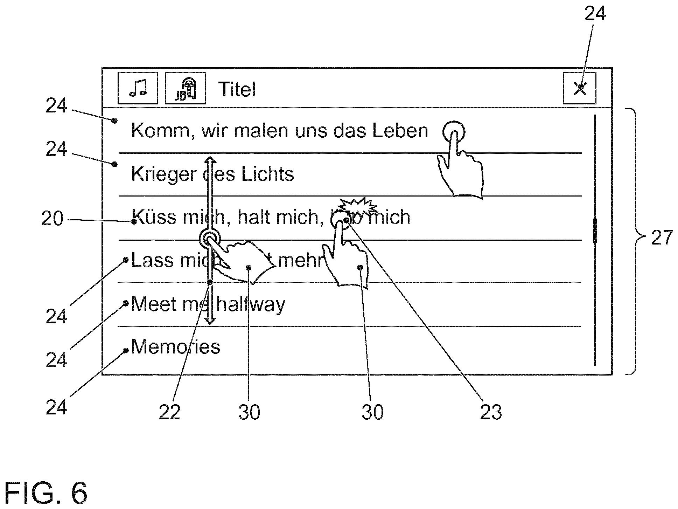

In Fig. 6 sind beispielshaft eine Auswahlliste 27, sowie die beiden Eingabearten dargestellt. Die Auswahlliste 27 besteht aus einem virtuellen Bedienelement 20 und mehreren weiteren virtuellen Bedienelementen 24. Die Auswahlliste 27 kann über eine Berührgeste, hier beispielsweise das Bewegen der Berührposition des Fingers 30 des Bedieners nach oben und unten, gerollt werden, so dass das virtuelle Bedienelement 20 und die weiteren virtuellen Bedienelemente 24 verschoben werden und, wenn vorhanden, andere weitere virtuelle Bedienelemente 24 sichtbar und auswählbar werden. Wenn gewünscht, kann durch die Berührgeste 22 ausgelöst, eine haptische oder akustische Rückkopplung durch Ausgabe eines entsprechenden Signals am Aktorelement oder am Lautsprecher erfolgen. Wünscht der Bediener nun die Auswahl eines Listeneintrags, beispielsweise eines Musiktitels, so führt er auf dem Listeneintrag eine Druckgeste 23 aus und führ dadurch eine Bedienelementfunktion, hier der Auswahl bzw. des Abspielens des Musiktitels, aus. Die Rückkopplung erfolgt analog zu der Beschreibung der Figuren 4 und 5.

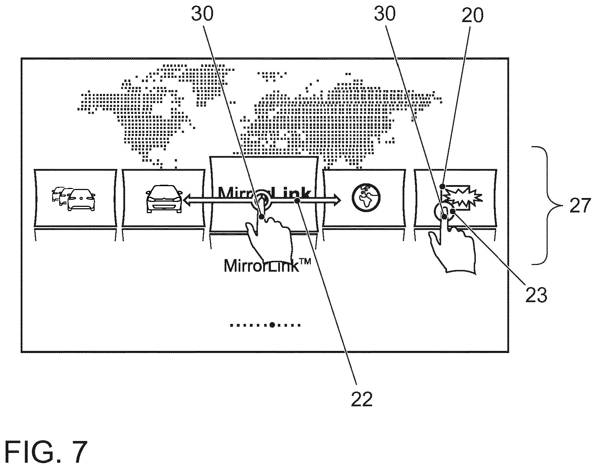

In Fig. 7 sind schematisch die beiden Eingabearten für eine Auswahlliste 27 dargestellt, welche horizontal ausgebildet ist. Das Rollen der Liste erfolgt hier über eine Berührgeste 22 in seitliche Richtung. Die Auswahl eines Listeneintrags und die haptische bzw. akustische Rückkopplung erfolgen analog wie in der Beschreibung von Fig. 6 geschildert über eine Druckgeste 23 des Fingers 30 des Bedieners.

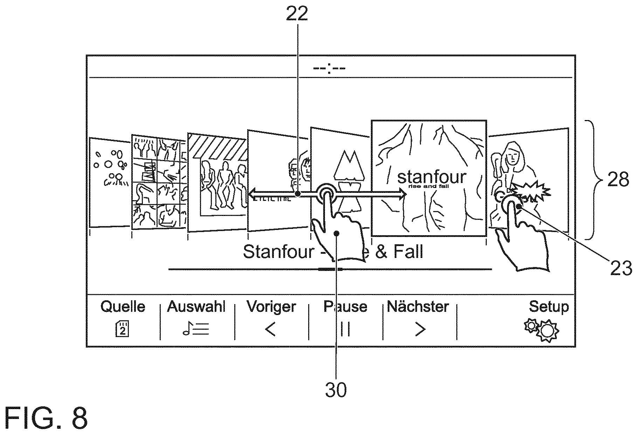

In Fig. 8 sind die beiden Eingabearten für eine Coverliste 28 dargestellt, welche sich aus verschiedenen Covern von Musikalben zusammensetzt. Das Rollen der Liste erfolgt hier wieder über eine Berührgeste 22 in seitliche Richtung. Die Auswahl eines Listeneintrags, hier eines Albums, und die haptische bzw. akustische Rückkopplung erfolgen analog wie in der Beschreibung von Fig. 6 und Fig. 7 geschildert über eine Druckgeste 23 auf das virtuelle Bedienelement 20 des Fingers 30 des Bedieners.

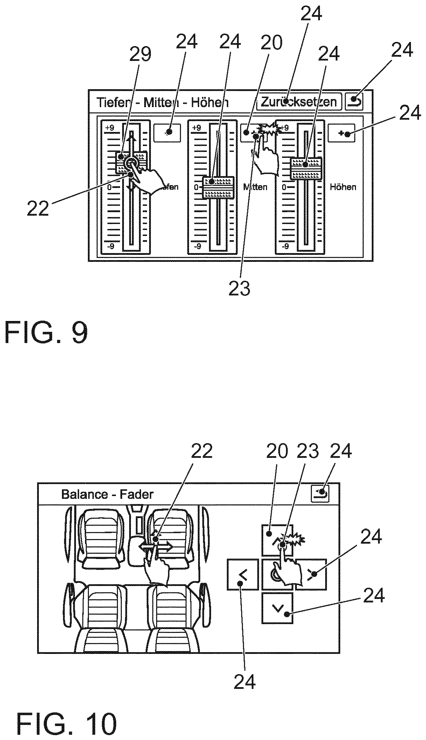

Fig. 9 zeigt schematisch die zwei Eingabearten für eine Bedienung von Knöpfen und Schiebereglern 29, welche als virtuelles Bedienelement 20 bzw. weitere virtuelle Bedienelemente 24 ausgebildet sind. Der Schieberegler 29 wird in dieser Ausführungsform durch eine einfache Berührgeste 22 hin- und herbewegt. Denkbar ist aber auch, dass ein Schieberegler 29 erst über eine Druckgeste 23 entriegelt werden muss, dann bewegbar ist über eine Berührgeste 22 und anschließend wieder verriegelt bzw. arretiert werden muss. Das Auslösen der Bedienelementfunktion des virtuellen Bedienelements 20, das hier einen Knopf darstellt, erfolgt durch eine Druckgeste 23. Die haptische bzw. akustische Rückkopplung erfolgt analog wie in den Beschreibungen der Figuren 4-8 geschildert.

In den Figuren wird stets ein Finger des Bedieners 30 als Betätigungselement verwendet. Generell sind aber auch andere Betätigungselemente denkbar. Beispielsweise können diese Kleidungsstücke sein, welche den Finger des Bedieners 30 umgeben, oder aber auch Stifte oder sonstige Objekte.

Fig. 10 zeigt schematisch die zwei Eingabearten für eine Bedienung von nachgebildeten Tastern, welche als virtuelles Bedienelemente 20 bzw. weitere virtuelle Bedienelemente 24 ausgebildet sind. Über eine Berührgeste 22 auf der graphischen Darstellung einer Draufsicht der Fahrgastzelle, kann ein Fadenkreuz positioniert werden, das anschließend, beispielsweise als Mittelposition einer Musikwiedergabe, definiert wird. Die mit dem rechts davon dargestellten virtuellen Bedienelement 20 des Tasters verknüpfte Bedienelementfunktion, hier das schrittweise Verschieben der Mittelposition (Balance) der Musikwiedergabe, wird durch eine Druckgeste 23 ausgelöst. Die haptische bzw. akustische Rückkopplung erfolgt analog wie in den Beschreibungen der Figuren 4-9 geschildert.

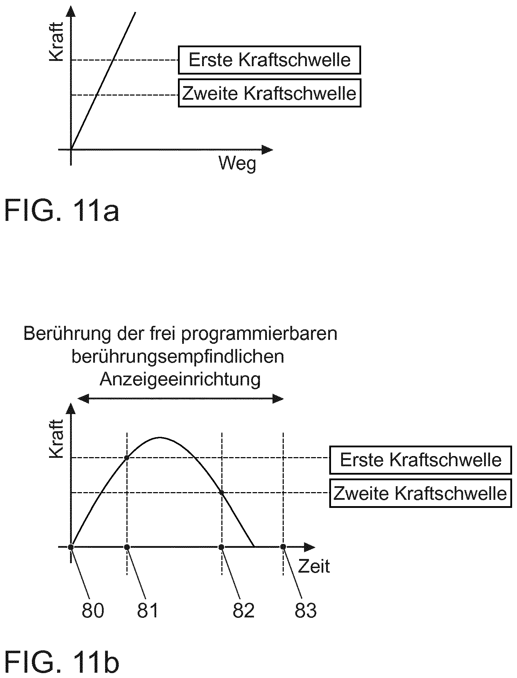

Die Figuren 11a und 11b zeigen beispielhaft einen schematischen Verlauf der Anpressdruckkraft während einer Druckgeste, sowie über eine erste und eine zweite Kraftschwelle ausgelöste haptische, und optional akustische, Rückkopplungen. Zu Beginn der Druckgeste ist der Finger auf eine frei programmierbare berührungsempfindliche Anzeigeeinrichtung aufgelegt 80. Der Bediener erhöht dann die Anpressdruckkraft, wobei hier, wie in Fig. 11a dargestellt, von einer linearen Beziehung zwischen senkrechter Auslenkung der frei programmierbaren berührungsempfindlichen Anzeigeeinrichtung und der resultierenden bzw. durch den Druckkraftsensor erfassten Anpressdruckkraft ausgegangen wird. Die Anpressdruckkraft überschreitet dann die erste Kraftschwelle, was zu einer Ausgabe einer haptischen Rückkopplung führt 81. Optional wird zeitgleich oder zeitlich nach- oder vorverzögert eine akustische Rückkopplung über einen Lautsprecher ausgegeben. Anschließend überschreitet die Anpressdruckkraft ein Maximum und wird dann wieder kleiner. Bei Unterschreiten einer zweiten Kraftschwelle wird eine weitere haptische Rückkopplung über das Aktorelement ausgegeben, und optional dazu eine weitere akustische Rückkopplung über den Lautsprecher 82. Zum Schluss der Druckgeste wird der Finger wieder abgehoben 83. Denkbar ist aber auch, dass der Finger auf der frei programmierbaren berührungsempfindlichen Anzeigeeinrichtung verbleibt, um beispielsweise weitere Berührgesten oder Druckgesten durchzuführen.

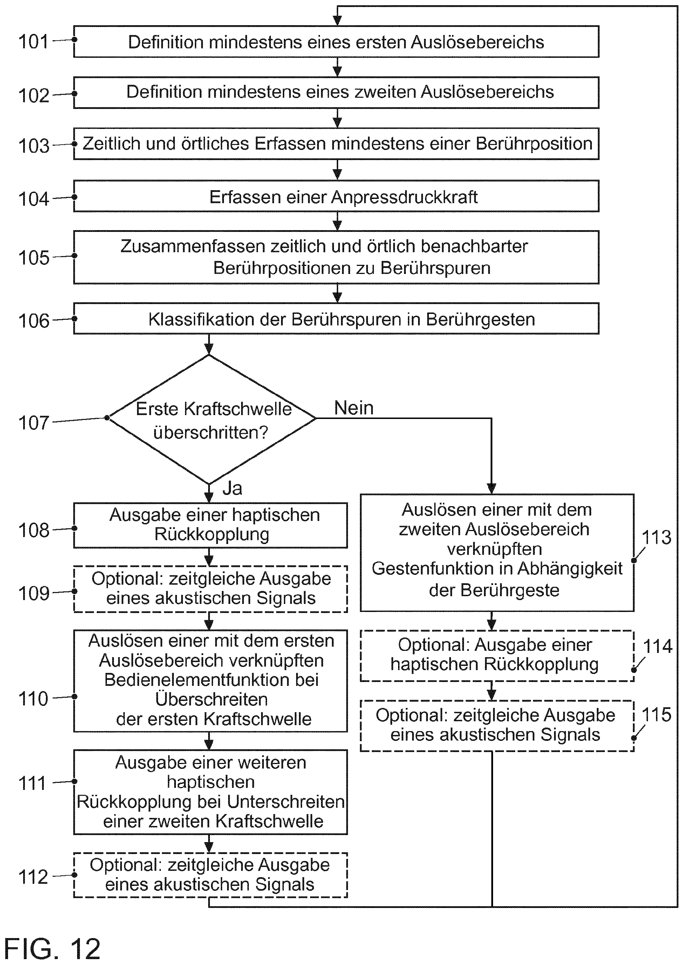

In Fig. 12 ist ein schematisches Ablaufdiagramm des Verfahrens zum Erfassen von Daten in einem Kraftfahrzeug über die beiden Eingabearten dargestellt. Zuerst wird mindestens ein erster Auslösebereich mit virtuellen Bedienelementen definiert 101. Anschließend wird mindestens ein zweiter Auslösebereich definiert 102. Anschließend wird zeitlich und örtlich mindestens eine Berührposition, beispielsweise auf einer frei programmierbaren berührungsempfindlichen Anzeigeeinrichtung, erfasst 103. Zusätzlich wird eine Anpressdruckkraft erfasst 104. Anschließend erfolgt ein zeitliches und örtliches Zusammenfassen benachbarter Berührpositionen zu Berührspuren 105, welche dann nach Berührgesten klassifiziert werden 106. Ist eine erste Kraftschwelle überschritten 107, so erfolgt eine haptische Rückkopplung 108. Optional kann zeitgleich oder nach- oder vorverzögert eine zusätzliche akustische Rückkopplung erfolgen 109. Durch Überschreiten der ersten Kraftschwelle wird eine mit dem ersten Auslösebereich verknüpfte Bedienelementfunktion ausgelöst 110. Beim anschließenden Unterschreiten einer zweiten Kraftschwelle erfolgt eine weitere haptische Rückkopplung 111 und optional eine weitere akustische Rückkopplung 111. Ist die erste Kraftschwelle nicht überschritten 107, so wird in Abhängigkeit der Berührgeste eine mit dem zweiten Auslösebereich verknüpfte Berührfunktion ausgelöst 113. Optional kann beim Auslösen der Berührfunktion eine haptische Rückkopplung 114 und ebenfalls optional zeitgleich oder nach- oder vorverzögert mit der haptischen Rückkopplung eine akustische Rückkopplung ausgegeben werden 115. Anschließend erfolgt ein erneuter Durchlauf des Verfahrens. Die Schritte und/oder Aktionen, die mit den Bezugszeichen 108 bis 115 gekennzeichnet sind, werden nur vorgenommen oder ausgeführt, wenn die Berührposition, die in einer vorgegebenen Zeitspanne vor dem Überschreiten der ersten Kraftschwelle durch den erfassten Anpressdruck erfasst wird, in dem ersten Auslösebereich der entsprechend hiermit verknüpften Bedienelementfunktion liegen.

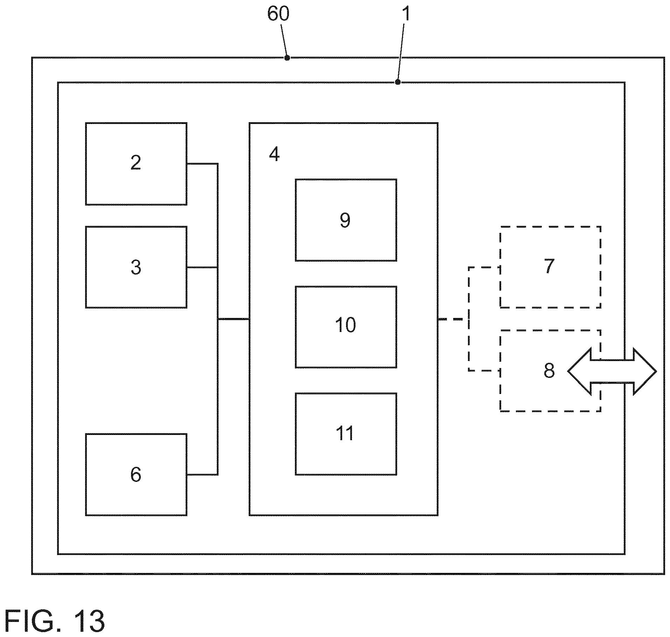

In Fig. 13 ist eine Ausführungsform der Vorrichtung 1 zur Eingabe von Daten gezeigt. In einer Mensch-Maschine-Schnittstelle 60 befindet sich die Vorrichtung 1. Eine solche Mensch-Maschine-Schnittstelle 60 kann beispielsweise ein Computer, ein Laptop, ein Tabletcomputer, ein Smartphone, ein interaktiver Tisch, ein Fahrkartenautomat, eine Infosäule, eine interaktive Steuerungsvorrichtung, beispielsweise in Leitständen, sein. Die Vorrichtung 1 umfasst eine frei programmierbare berührungsempfindliche Anzeigeeinrichtung 2, mit der direkt oder indirekt ein Aktorelement 3 und ein Druckkraftsensor 6 verbunden sind. Die frei programmierbare berührungsempfindliche Anzeigeeinrichtung 2 weist eine Berührfläche 12 auf. Die frei programmierbare berührungsempfindliche Anzeigeeinrichtung 2, das Aktorelement 3 und der Druckkraftsensor 6 sind mit einer Steuereinrichtung 4 verbunden. Die Steuereinrichtung 4 umfasst eine Integriereinrichtung 9, eine Klassifikationseinrichtung 10 und eine Vergleichseinrichtung 11. Optional kann die Vorrichtung 1 einen mit der Steuereinrichtung 4 verbundenen Lautsprecher 7, vorzugsweise an oder in der Nähe der frei programmierbaren berührungsempfindlichen Anzeigeeinrichtung 2, aufweisen. Ebenfalls optional ist eine mit der Steuereinrichtung 4 verbundene Schnittstelle 8 zur Kommunikation mit externen Geräten, beispielsweise über ein Bussystem, ein anderes Netzwerk oder das Internet.

Von der Steuereinrichtung 4 werden virtuelle Bedienelemente und erste und zweite Auslösebereiche definiert. Die virtuellen Bedienelemente werden als graphische Repräsentation auf der frei programmierbaren berührungsempfindlichen Anzeigeeinrichtung 2 dargestellt. Darüber hinaus können durch die Steuereinrichtung 4 weitere graphische Repräsentationen, Symbole, Buchstaben oder Piktogramme auf der frei programmierbaren berührungsempfindlichen Anzeigeeinrichtung 2 dargestellt werden. Von der frei programmierbaren berührungsempfindlichen Anzeigeeinrichtung 2 wird mindestens eine Berührposition erfasst und der Steuereinrichtung 4 zugeführt. Die Integriereinrichtung 9 fasst zeitlich und örtlich benachbarte Berührpositionen zu Berührspuren zusammen und gibt die Berührspuren an die Klassifikationseinrichtung 10 weiter. Die Klassifikationseinrichtung 10 klassifiziert die Berührungsspuren nach Berührgesten.

Zeitgleich mit dem Erfassen der mindestens einen Berührposition wird ein Anpressdruck auf die frei programmierbare berührungsempfindliche Anzeigeeinrichtung 2 von dem Druckkraftsensor 6 erfasst und an die Steuereinrichtung 4 weitergeleitet. Die Vergleichseinrichtung 11 vergleicht nun die klassifizierten Berührspuren und den Anpressdruck beispielsweise mit einer in der Vergleichseinrichtung 11 oder der Steuereinrichtung 4 hinterlegten Liste von Berührfunktionen und Bedienelementfunktionen. Erfüllt eine klassifizierte Berührspur die Kriterien einer der in der Liste gespeicherten Berührfunktionen, so wird die entsprechende Berührfunktion ausgelöst. Optional kann die Steuereinrichtung 4 bei Auslösen der Berührfunktion zeitgleich ein Signal am Aktorelement 3 und/oder ein weiteres Signal am Lautsprecher 7 ausgeben. Ist eine erste Kraftschwelle am Druckkraftsensor 6 überschritten und liegen die in einer vorgegeben Zeitspanne hiervor erfassen Berührpositionen alle in dem Auslösebereich eines virtuellen Bedienelements, so wird die diesem Bedienelement zugeordnete Bedienelementfunktion ausgelöst und die Steuereinrichtung 4 gibt beim Überschreiten der ersten Kraftschwelle ein Signal am Aktorelement 3 aus; wird anschließend eine zweite Kraftschwelle am Druckkraftsensor 6 unterschritten, so gibt die Steuereinrichtung 4 ein weiteres Signal an dem Aktorelement 3 aus. Optional kann beim Überschreiten der ersten Kraftschwelle und/oder beim Unterschreiten der zweiten Kraftschwelle jeweils zeitgleich oder gegenüber dem entsprechenden Signal an das Aktorelement 3 nach- bzw. vorverzögert ein Signal oder mehrere Signale von der Steuereinrichtung 4 auf dem Lautsprecher 7 ausgegeben werden. Eine Überprüfung, ob alle Berührpositionen in der vorgegebenen Zeitspanne vor dem Überschreiten der ersten Kraftschwelle in dem Auslösebereichs eines virtuellen Bedienelements lagen oder liegen, kann beispielsweise von der Vergleichseinrichtung zum Klassifizieren der Berührspuren durchgeführt werden. Dafür wird der dem virtuellen Bedienelement zugeordnete erste Auslösebereich wie ein zweiter Auslösebereich behandelt, wobei eine Berührspur als stationär oder quasistationär klassifiziert wird, wenn alle Berührpositionen in dem vorgegebenen Auslösebereich liegen. Wird somit eine stationäre oder quasi stationäre Berührspur für einen ersten Auslösebereich klassifiziert, ist die Bedingung erfüllt, sofern die Berührspur zumindest alle Berührpositionen umfasst, die innerhalb der vorgegeben Zeitspanne liegen.

Je nach Art der Berührfunktion oder Bedienelementfunktion, die ausgelöst wurde, kann die Steuereinrichtung 4 die graphische Darstellung auf der frei programmierbaren berührungsempfindlichen Anzeigeeinrichtung 2 verändern oder unverändert lassen. Optional können die Berührposition, der Anpressdruck, die Berührspur und/oder weitere Daten an der Schnittstelle 8 ausgegeben werden. Ebenfalls möglich ist, dass die Steuereinrichtung 4 über die Schnittstelle 8 parametriert wird, beispielsweise von einem Zentralcomputer der Mensch-Maschine-Schnittstelle 60.

Vorzugsweise ist die Vorrichtung 1 so ausgebildet, dass die Aufgaben der Integriereinrichtung 9, der Klassifikationseinrichtung 10, der Vergleichseinrichtung 11, sowie allgemein der Steuereinrichtung 4 softwaremäßig, beispielsweise in einem einzigen Computer oder Mikrocontroller, durchgeführt werden.

### Bezugszeichenliste

- 1: Vorrichtung
- 2: frei programmierbare berührungsempfindliche Anzeigeeinrichtung
- 3: Aktorelement
- 4: Steuereinrichtung
- 6: Druckkraftsensor
- 7: Lautsprecher
- 8: Schnittstelle
- 9: Integriereinrichtung
- 10: Klassifikationseinrichtung
- 11: Vergleichseinrichtung
- 12: Berührfläche
- 20: virtuelles Bedienelement
- 21: Straßenkarte
- 22: Berührgeste
- 23: Druckgeste
- 24: weiteres virtuelles Bedienelement
- 25: Tastatur
- 26: Eingabefeld
- 27: Auswahlliste
- 28: Coverliste
- 30: Finger des Bedieners
- 40: multimediale Anzeige-Bedienvorrichtung
- 41: Frontblende
- 42: weitere Gehäuseteile
- 43: Endlosdrehregler
- 44: physisch ausgebildete Taste
- 50: Kraftfahrzeug
- 60: Mensch-Maschine-Schnittstelle
- 80-83: Verlauf einer Druckgeste
- 101-115: Verfahrensschritte

## Patentansprüche

1. Eingabeverfahren, insbesondere in einem Kraftfahrzeug (50), mit haptischer Rückkopplung, die folgenden Schritte umfassend:
Darstellen mindestens eines virtuellen Bedienelements auf einer frei programmierbaren berührungsempfindlichen Anzeigeeinrichtung (103),
Erfassen einer Berührposition auf der frei programmierbaren berührungsempfindlichen Anzeigeeinrichtung (103),
Selektion einer Funktion über die Berührposition (110),
Erfassen einer Anpressdruckkraft auf die frei programmierbare berührungsempfindliche Anzeigeeinrichtung (104),
Auslösen der selektierten Funktion durch Überschreiten einer ersten Kraftschwelle (110),
Ausgabe einer haptischen Rückkopplung (108),
wobei zeitlich und örtlich benachbarte Berührpositionen zu Berührspuren zusammengefasst werden (105) und die Berührspuren nach Berührgesten klassifiziert werden (106),
**dadurch gekennzeichnet, dass**
Funktionen in Berührfunktionen und Bedienelementfunktionen unterteilt werden (101, 102),
wobei eine der Bedienelementfunktionen dem mindestens einen virtuellen Bedienelement zugeordnet ist, und die Selektion der einen Bedienelementfunktion erfolgt, wenn die Berührpositionen, während eines festgelegten Zeitintervalls in dem Auslösebereich des mindestens einen virtuellen Bedienelement liegen, dem die Bedienelementfunktion zugeordnet ist, und ein Auslösen der einen Bedienelementfunktion erfolgt, wenn die erste Kraftschwelle überschritten wird (110), während die eine Bedienelementfunktion selektiert ist, wobei bei diesem Überschreiten der ersten Kraftschwelle eine haptische Rückkopplung ausgegeben wird (108) und nach anschließendem Unterschreiten einer zweiten Kraftschwelle eine weitere von der ersten unterschiedliche haptische Rückkopplung ausgegeben wird (111), und
dass mindestens einem zweiten Auslösebereich auf der frei programmierbaren berührungsempfindlichen Anzeigeeinrichtung mindestens eine Berührfunktion zugeordnet ist, welche durch eine festgelegte Berührgeste ausgelöst wird (113).

2. Verfahren nach Anspruch 1, **dadurch gekennzeichnet,**
**dass** zeitgleich mit den haptischen Rückkopplungen ein akustisches Signal ausgegeben wird (109, 112, 115).

3. Verfahren nach einem der Ansprüche 1 oder 2, **dadurch gekennzeichnet,**
**dass** sich der erste und der zweite Auslösebereich überlappen.

4. Verfahren nach einem der Ansprüche 1 bis 3, **dadurch gekennzeichnet,**
**dass** eine Bedienelementfunktion bei Überschreiten der ersten Kraftschwelle nicht ausgelöst wird, wenn das Überschreiten an einer erfassten Berührposition erfolgt, die Bestandteil einer als Berührgeste klassifizierte Berührspur ist.

5. Verfahren nach einem der Ansprüche 1 bis 4, **dadurch gekennzeichnet,**
**dass** die haptischen Rückkopplungen als impulsartige Auslenkungen einer Berührfläche (12) der frei programmierbaren Anzeigefläche (2) ausgeführt werden..

6. Verfahren nach einem der Ansprüche 1 bis 5, **dadurch gekennzeichnet,**
**dass** bei oder nach Auslösen einer Berührfunktion eine haptische Rückkopplung gegeben wird (114).

7. Verfahren nach einem der Ansprüche 1 bis 6, **dadurch gekennzeichnet,**
**dass** es nach Überschreiten der ersten Kraftschwelle zum Auslösen einer Bedienelementfunktion weitere Kraftschwellen gibt, bei denen durch Über- oder Unterschreiten eine haptische Rückkopplung gegeben wird.

8. Verfahren nach einem der Ansprüche 1 bis 7, **dadurch gekennzeichnet,**
**dass** die erste und die zweite und, wenn vorhanden, die weitere Kraftschwelle und die dazugehörigen haptischen Rückkopplungen so ausgeführt sind, dass eine physikalische Taste nachgebildet ist.

9. Verfahren nach einem der Ansprüche 1 bis 8, **dadurch gekennzeichnet,**
**dass** an einer Schnittstelle die erfasste Berührposition, Informationen über die ausgelösten Bedienelementfunktionen und Berührfunktionen und/oder weitere Daten bereitgestellt werden.

10. Verfahren nach einem der Ansprüche 1 bis 9, **dadurch gekennzeichnet,**
**dass** das Eingabeverfahren über eine Schnittstelle gesteuert wird.

11. Verfahren nach einem der Ansprüche 1 bis 10, **dadurch gekennzeichnet,**
**dass** die auf der berührungsempfindlichen Anzeige dargestellte Information in Abhängigkeit davon verändert wird, ob eine Berührfunktion oder einer Bedienelementfunktion ausgelöst wurde.

12. Vorrichtung (1), insbesondere in einem Kraftfahrzeug (50), zur interaktiven Eingabe von Daten mit haptischer Rückkopplung, umfassend:
eine frei programmierbare berührungsempfindliche Anzeigeeinrichtung (2) zum Erfassen einer Berührposition und Darstellen von Information,
einen mit der frei programmierbaren berührungsempfindlichen Anzeigeeinrichtung (2) direkt oder indirekt verbundenen Druckkraftsensor (6) zum Erfassen einer Anpressdruckkraft,
ein mit der frei programmierbare berührungsempfindliche Anzeigeeinrichtung (2) direkt oder indirekt verbundenes Aktorelement (3) zum Ausgeben einer haptischen Rückkopplung,
eine Steuereinrichtung (4),
wobei die Steuereinrichtung (4) so ausgebildet ist, dass sie zeitlich und räumlich benachbarte Berührpositionen zu Berührspuren zusammenfasst und nach Berührgesten klassifiziert,
und wobei die Steuereinrichtung (4) ausgebildet ist, mindestens ein virtuelles Bedienelement (20) auf der frei programmierbaren berührungsempfindlichen Anzeigeeinrichtung darzustellen,
**dadurch gekennzeichnet, dass**
dem mindestens einen virtuellen Bedienelement ein erster Auslösebereich auf der frei programmierbaren berührungsempfindlichen Anzeigeeinrichtung und eine Bedienelementfunktion zugeordnet ist,
und die Steuereinrichtung (4) ausgebildet ist, die Anpressdruckkraft zu überwachen und bei einem Überschreiten einer ersten Kraftschwelle die Bedienelementfunktion auszulösen, sofern die während eines festgelegten Zeitintervalls zuvor erfassten Berührpositionen in dem Auslösebereich des mindestens einen virtuellen Bedienelement liegen, dem die Bedienelementfunktion zugeordnet ist, wobei bei diesem Überschreiten der ersten Kraftschwelle von der Steuereinrichtung (4) ein Signal an das Aktorelement (3) ausgegeben wird und nach anschließendem Unterschreiten einer zweiten Kraftschwelle ein weiteres von dem ersten Signal unterschiedliches Signal am Aktorelement (3) ausgegeben wird,
dass die Steuereinrichtung (4) mindestens einem zweiten Auslösebereich auf der frei programmierbaren berührungsempfindlichen Anzeigeeinrichtung (2) mindestens eine Berührfunktion zuordnet und bei Auftreten einer festgelegten Berührgeste die mindestens eine Berührfunktion auslöst.

13. Vorrichtung nach Anspruch 12, **dadurch gekennzeichnet,**
**dass** die Steuereinrichtung bei Auslösen einer Berührfunktion ein Signal an das Aktorelement (3) ausgibt.

14. Vorrichtung nach Anspruch 12 oder 13, **dadurch gekennzeichnet,**
**dass** die Vorrichtung einen Lautsprecher (7) umfasst, und an diesem Lautsprecher (7) zeitgleich oder nach- oder vorverzögert zum Ausgeben der haptischen Rückkopplungen von der Steuereinrichtung (4) ein akustisches Signal ausgegeben wird.

15. Vorrichtung nach einem der Ansprüche 12 bis 14, **dadurch gekennzeichnet,**
**dass** die Vorrichtung eine Schnittstelle (8) umfasst, an der von der Steuereinrichtung (4) Daten ausgegeben und empfangen werden kann.

16. Vorrichtung nach Anspruch 15, **dadurch gekennzeichnet,**
**dass** die Steuereinrichtung (4) von einem Zentralrechner oder einem anderen Mikrocontroller gesteuert wird.

## Claims

1. Input method, in particular in a motor vehicle (50), with haptic feedback, comprising the following steps:
presentation of at least one virtual operator control element on a user programmable touch-sensitive display device (103), sensing of a touch position on the user programmable touch-sensitive display device (103),
selection of a function via the touch position (110), sensing of a contact pressure force on the user programmable touch-sensitive display device (104),
initiation of the selected function when a first force threshold (110) is exceeded,
output of haptic feedback (108),
wherein
temporally and locally adjacent touch positions are combined (105) to form touch traces and the touch traces are classified (106) according to touch gestures, **characterized**
**in that** functions are divided into touch functions and operator control element functions (101, 102),
wherein one of the operator control element functions is associated with the at least one virtual operator control element, and the one operator control element function is selected when the touch positions, during a stipulated time interval, are located in the initiation region of the at least one virtual operator control element with which the operator control element function is associated, and the one operator control element function is initiated when the first force threshold is exceeded (110) while the one operator control element function is selected, wherein this exceeding of the first force threshold prompts haptic feedback to be output (108), and a subsequent drop below a second force threshold is followed by further haptic feedback, which is different than the first, being output (111), and
**in that** at least one second initiation region on the user programmable touch-sensitive display device has at least one associated touch function that is initiated by a stipulated touch gesture (113).

2. Method according to Claim 1, **characterized**
**in that** at the same time as the haptic feedback items, an audible signal is output (109, 112, 115).

3. Method according to either of Claims 1 and 2, **characterized**
**in that** the first and second initiation regions overlap.

4. Method according to one of Claims 1 to 3, **characterized**
**in that** an operator control element function is not initiated when the first force threshold is exceeded if the exceeding takes place at a sensed touch position that is part of a touch trace classified as a touch gesture.

5. Method according to one of Claims 1 to 4, **characterized**
**in that** the haptic feedback items are embodied as pulsed deflections of a touch area (12) of the user programmable display area (2).

6. Method according to one of Claims 1 to 5, **characterized**
**in that** initiation of a touch function prompts or is followed by provision of a haptic feedback item (114).

7. Method according to one of Claims 1 to 6, **characterized**
**in that** after the first force threshold for initiation of an operator control element function has been exceeded there are further force thresholds that, as a result of being exceeded or experiencing a drop below them, prompt provision of a haptic feedback item.

8. Method according to one of Claims 1 to 7, **characterized**
**in that** the first and the second and, if present, the further force threshold and the associated haptic feedback items are embodied such that a physical key is simulated.

9. Method according to one of Claims 1 to 8, **characterized**
**in that** an interface is used to provide the sensed touch position, information about the initiated operator control element functions and touch functions and/or further data.

10. Method according to one of Claims 1 to 9, **characterized**
**in that** the input method is controlled via an interface.

11. Method according to one of Claims 1 to 10, **characterized**
**in that** the information presented on the touch-sensitive display is altered on the basis of whether a touch function or an operator control element function has been initiated.

12. Apparatus (1), in particular in a motor vehicle (50), for the interactive input of data with haptic feedback, comprising:
a user programmable touch-sensitive display device (2) for sensing a touch position and presenting information, a pressure force sensor (6), which is directly or indirectly connected to the user programmable touch-sensitive display device (2), for sensing a contact pressure force,
an actuator element (3), which is directly or indirectly connected to the user programmable touch-sensitive display device (2), for outputting a haptic feedback item,
a control device (4),
wherein
the control device (4) is in a form such that it combines temporally and locally adjacent touch positions to form touch traces and classifies them according to touch gestures,
and wherein the control device (4) is designed to present at least one virtual operator control element (20) on the user programmable touch-sensitive display device,
**characterized**
**in that** the at least one virtual operator control element is assigned a first initiation region on the user programmable touch-sensitive display device and an operator control element function,
and the control device (4) is designed to monitor the contact pressure force and, in the event of a first force threshold being exceeded, to initiate the operator control element function, provided that the touch positions previously sensed during a stipulated time interval are located in the initiation region of the at least one virtual operator control element with which the operator control element function is associated, wherein this exceeding of the first force threshold prompts the control device (4) to output a signal to the actuator element (3), and a subsequent drop below a second force threshold is followed by a further signal, which is different than the first signal, being output on the actuator element (3), in that the control device (4) associates at least one touch function with at least one second initiation region on the user programmable touch-sensitive display device (2) and, when a stipulated touch gesture occurs, initiates the at least one touch function.

13. Apparatus according to Claim 12, **characterized**
**in that** the control device outputs a signal to the actuator element (3) when a touch function is initiated.

14. Apparatus according to Claim 12 or 13, **characterized**
**in that** the apparatus comprises a loudspeaker (7), and an audible signal is output by the control device (4) on this loudspeaker (7) at the same time as or with a subsequent or prior delay in relation to the output of the haptic feedback items.

15. Apparatus according to one of Claims 12 to 14, **characterized**
**in that** the apparatus comprises an interface (8) that the control device (4) can use to output and receive data.

16. Apparatus according to Claim 15, **characterized in that** the control device (4) is controlled by a central computer or another microcontroller.

## Revendications

1. Procédé de saisie, notamment dans un véhicule automobile (50), avec retour haptique, le procédé comprenant les étapes suivantes :
représenter au moins un élément de commande virtuel sur un dispositif d'affichage tactile (103) librement programmable,
détecter une position tactile sur l'écran tactile librement programmable (103),
sélectionner une fonction par le biais de la position tactile (110),
détecter une force de pression de contact sur le dispositif d'affichage tactile (104) librement programmable,
déclencher la fonction sélectionnée par franchissement vers le haut d'un premier seuil de force (110),
délivrer un retour haptique (108),
des positions tactiles temporellement et localement adjacentes étant combinées pour former des pistes tactiles (105) et les pistes tactiles étant classées selon des gestes tactiles (106),
**caractérisé en ce que**
les fonctions sont divisées en fonctions tactiles et en fonctions de commande (101, 102),
l'une des fonctions de commande étant associée à l'au moins un élément de commande virtuel, et la sélection de la première fonction de commande étant effectuée lorsque les positions tactiles se situent, pendant un intervalle de temps spécifié, dans la zone de déclenchement de l'au moins un élément de commande virtuel auquel la fonction d'élément de commande est associée, et un déclenchement de l'une des fonctions d'élément de commande étant effectué lors du franchissement vers le haut (110) du premier seuil de force pendant que la fonction d'élément de commande est sélectionnée, un retour haptique étant délivré (108) lors de ce franchissement vers le haut de ce premier seuil de force et, après franchissement vers le bas d'un deuxième seuil de force, un autre retour haptique, différent du premier, étant délivré (111), et **en ce qu'**au moins une deuxième zone de déclenchement sur le dispositif d'affichage tactile librement programmable est associée à au moins une fonction tactile qui est déclenchée (113) par un geste tactile spécifié.

2. Procédé selon la revendication 1, **caractérisé en ce qu'**un signal acoustique est délivré (109, 112, 115) en même temps que les retours haptiques.

3. Procédé selon l'une des revendications 1 ou 2, **caractérisé en ce que** les première et deuxième zones de déclenchement se chevauchent.

4. Procédé selon l'une des revendications 1 à 3, **caractérisé en ce qu'**une fonction d'élément de commande n'est pas déclenchée lors du franchissement vers le haut du premier seuil de force si le franchissement vers le haut est effectué à une position tactile détectée qui fait partie d'une piste tactile classée comme geste tactile.

5. Procédé selon l'une des revendications 1 à 4, **caractérisé en ce que** les retours haptiques sont réalisés sous forme de déviations en forme d'impulsions d'une surface tactile (12) de la surface d'affichage librement programmable (2).

6. Procédé selon l'une quelconque des revendications 1 à 5, **caractérisé en ce que** le retour haptique est délivré (114) pendant ou après le déclenchement d'une fonction tactile.

7. Procédé selon l'une des revendications 1 à 6, **caractérisé en ce que**, après franchissement vers le haut du premier seuil de force pour déclencher une fonction d'élément de commande, il existe d'autres seuils de force pour lesquels un retour haptique est délivré par franchissement vers le haut ou vers le bas.

8. Procédé selon l'une des revendications 1 à 7, **caractérisé en ce que** les premier et deuxième seuils de force et, le cas échéant, les autres seuils de force et les retours haptiques associés sont conçus de manière à simuler une touche de clavier physique.

9. Procédé selon l'une des revendications 1 à 8, **caractérisé en ce que** la position tactile détectée, des informations sur les fonctions de commande déclenchées et les fonctions tactiles et/ou d'autres données sont fournies au niveau d'une interface.

10. Procédé selon l'une des revendications 1 à 9, **caractérisé en ce que** le procédé de saisie est commandé par le biais d'une interface.

11. Procédé selon l'une des revendications 1 à 10, **caractérisé en ce que** les informations représentées sur l'affichage tactile sont modifiées en fonction du déclenchement d'une fonction tactile ou d'une fonction d'élément de commande.

12. Dispositif (1), en particulier dans un véhicule automobile (50), de saisie interactive de données avec retour haptique, le dispositif comprenant :
un dispositif d'affichage tactile (2) librement programmable destiné à détecter une position tactile et à représenter des informations,
un capteur de force de pression (6) connecté directement ou indirectement au dispositif d'affichage tactile (2) librement programmable et destiné à détecter une force de pression de contact,
un élément d'actionnement (3) connecté directement ou indirectement au dispositif d'affichage tactile (2) librement programmable et destiné à émettre un retour haptique,
un dispositif de commande (4),
le dispositif de commande (4) étant conçu de manière à combiner des positions tactiles temporellement et spatialement adjacentes pour former des pistes tactiles et à les classer en fonction de gestes tactiles,
et le dispositif de commande (4) étant conçu pour représenter au moins un élément de commande virtuel (20) sur le dispositif d'affichage tactile librement programmable,
**caractérisé en ce que**
l'au moins un élément de commande virtuel est associé à une première zone de déclenchement sur le dispositif d'affichage tactile librement programmable et une fonction d'élément de commande,
et le dispositif de commande (4) étant conçu pour surveiller la force de pression de contact et pour déclencher la fonction d'élément de commande lors d'un premier franchissement vers le haut d'un premier seuil de force à condition que les positions tactiles détectées précédemment pendant un intervalle de temps spécifié se situent dans la zone de déclenchement de l'au moins un élément de commande virtuel auquel la fonction d'élément de commande est associée, un signal étant délivré à l'élément d'actionnement (3) lors de ce franchissement vers le haut du premier seuil de force par le dispositif de commande (4), et après le franchissement vers le bas d'un deuxième seuil de force, un autre signal différent du premier signal étant délivré sur l'élément d'actionnement (3),
**en ce que** le dispositif de commande (4) associe une fonction tactile à au moins une deuxième zone de déclenchement sur le premier dispositif d'affichage tactile (2) librement programmable et déclenche l'au moins une fonction tactile lorsqu'un geste tactile spécifié se produit.

13. Dispositif selon la revendication 12, **caractérisé en ce que** le dispositif de commande délivre un signal à l'élément d'actionnement (3) lorsqu'une fonction tactile est déclenchée.

14. Dispositif selon la revendication 12 ou 13, **caractérisé en ce que** le dispositif comprend un haut-parleur (7) et **en ce qu'**un signal acoustique est délivré à ce haut-parleur (7) en même temps ou après ou avant la délivrance des retours haptiques par le dispositif de commande (4).

15. Dispositif selon l'une des revendications 12 à 14, **caractérisé en ce que** le dispositif comprend une interface (8) sur laquelle des données peuvent être délivrées et reçues par le dispositif de commande (4).

16. Dispositif selon la revendication 15, **caractérisé en ce que** le dispositif de commande (4) est commandé par un ordinateur central ou un autre microcontrôleur.
